**Europäisches Patentamt**

**European Patent Office**

**Office européen des brevets**

(19)

(11) **EP 1 158 304 A2**

(12) **EUROPÄISCHE PATENTANMELDUNG**

(43) Veröffentlichungstag:
**28.11.2001 Patentblatt 2001/48**

(51) Int Cl.7: **G01R 29/26**

(21) Anmeldenummer: **01440124.4**

(22) Anmeldetag: **02.05.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **17.05.2000 DE 10024326**

(71) Anmelder: **ALCATEL**
**75008 Paris (FR)**

(72) Erfinder:
• **Lu, Kang**
  **70806 Kornwestheim (DE)**
• **Matzner, Rolf, Dr.**
  **80995 München (DE)**
• **Panyaworayan, Witthaya**
  **85579 Neubiberg (DE)**

(74) Vertreter: **Dreiss, Fuhlendorf, Steimle & Becker**
**Patentanwälte**
**Postfach 10 37 62**
**70032 Stuttgart (DE)**

(54) **Verfahren und Vorrichtung zum Bestimmen des Signal-Rausch-Verhältnis eines Signals**

(57) Die Erfindung betrifft ein Verfahren zum Bestimmen des Signal-Rausch-Verhältnisses ($\rho$) eines Signals (y) mit Nutzsignalanteilen (x) und Rauschsignalanteilen (n) unter der Annahme, dass die Rauschsignalanteile (n) eine Gaussverteilung aufweisen. Um das Signal-Rausch-Verhältnis des Signals (y) insbesondere auch dann genau und zuverlässig berechnen zu können, wenn nur relativ wenige Messwerte (S) je Messintervall vorliegen bzw. wenn nur ein relativ schlechtes Signal (y) mit einem hohen Rauschsignalanteil (n) vorliegt, wird vorgeschlagen, dass das Signal (y) derart manipuliert wird, dass die Rauschsignalanteile (n) mit einer höheren Wahrscheinlichkeit eine Gaussverteilung aufweisen, bevor das Signal-Rausch-Verhältnis ($\rho$) bestimmt wird. Gemäß einer Weiterbildung wird vorgeschlagen, dass zu dem Signal (y) ein Rauschsignal (n') mit einer bekannten Leistung addiert wird. Das Rauschsignal (n') weist vorzugsweise eine Gaussverteilung auf.

Fig. 1

**Beschreibung**

Die vorliegende Erfindung betrifft ein Verfahren und eine Vorrichtung zum Bestimmen des Signal-Rausch-Verhältnisses eines Signals mit Nutzsignalanteilen und Rauschsignalanteilen unter der Annahme, dass die Rauschsignalanteile eine Gaussverteilung aufweisen. Die Erfindung betrifft des Weiteren ein Steuerelement für eine derartige Vorrichtung. Schließlich betrifft die Erfindung auch einen Empfänger einer nachrichtentechnischen Übertragungsstrecke mit einer Vorrichtung zum Bestimmen des Signal-Rausch-Verhältnisses eines empfangenen Signals mit Nutzsignalanteilen und Rauschsignalanteilen unter der Annahme, dass die Rauschsignalanteile eine Gaussverteilung aufweisen.

Das Signal-Rausch-Verhältnis wird in der Fachliteratur auch als Signal to Interference Ratio (SIR) oder als Signal to Noise Ratio (SNR) bezeichnet. Das Signal-Rausch-Verhältnis ist bspw. im Bereich der Funktelekommunikation bei Mobiltelefonen und Basisstationen ein Gütekriterium für die Übertragungsqualität.

Aus dem Stand der Technik sind eine ganze Reihe von Verfahren und Vorrichtungen zum Bestimmen des Signal-Rausch-Verhältnisses bekannt. So ist bspw. aus der Veröffentlichung von Matzner, R., Letsch, K., "SNR Estimation and Blind Equalization (Deconvolution) Using the Kurtosis", Proc. 1994 IEEE-IMS Workshop on Information Theory and Statistics, Alexandria, VA, Oct. 1994, p. 68, http://speedy.et.unibw-muenchen.de/forsch/ut/publ/itstat94/paper.html [1] ein Verfahren zum Bestimmen des Signal-Rausch-Verhältnisses mit Hilfe der Kurtosis beschrieben. Auf diese Veröffentlichung wird ausdrücklich Bezug genommen. Die Kurtosis ist der Quotient aus dem vierten Moment des Signals, dessen Signal-Rausch-Verhältnis bestimmt werden soll, und dem Quadrat des zweiten Moments des Signals. Die Kurtosis ist unabhängig von der Leistung des Signals.

Als weiterer Stand der Technik wird auf die Veröffentlichungen Benedict, T. R., Soong, T. T., "The joint estimation of signal and noise from the sum envelope", IEEE Trans. Inform. Theory, vol. IT-13, no. 3, pp. 447-454, 1967 [2]; Shah, B., Hinedi, S., "The split symbol moments SNR estimator in narrow-band channels", IEEE Trans. Aerospace and Electronic Systems, vol. 25, no. 5, pp. 737-747, 1990 [3]; Pauluzzi, D. R., Beaulieu, N. C., "A comparison of SNR estimation techniques in the AWGN channel", IEEE Symposium, Victoria, Canada, May 1995 [4]; Matzner, R., "Schätzung des Signalstörabstands mit Hilfe der Kurtosis", ITG-Diskussionssitzung "Höhere Momente: Algorithmen und ihre Anwendung", Darmstadt, Sept. 1994 [5] und auf die Diplomarbeit von Panyaworayan, W. an der Universität der Bundeswehr, München, Dez. 1998 [6] verwiesen, auf die ausdrücklich Bezug genommen wird.

Diese bekannten Verfahren und Vorrichtungen arbeiten mit zeitdiskreten Signalen. In vorgegebenen Messintervallen wird eine bestimmte Anzahl von Messwerten (Samples) des Signals aufgenommen und das Signal-Rausch-Verhältnis für diese Messwerte bestimmt, indem die Messwerte anhand bestimmter Gleichungen ausgewertet werden. All diesen bekannten Verfahren und Vorrichtungen ist gemeinsam, dass sie beim Bestimmen des Signal-Rausch-Verhältnisses zur Vereinfachung der Gleichungen von der Annahme ausgehen, dass der Rauschsignalanteil des Signals eine Gaussverteilung aufweist.

Diese Annahme gilt jedoch nur, wenn je Messintervall eine ausreichend große Anzahl von Messwerten aufgenommen wird. Bei einer zu geringen Anzahl von Messwerten wirken sich Ausreisser wesentlich stärker auf das Messergebnis aus und bewirken eine relativ große Abweichung des Messergebnisses von dem tatsächlichen Messwert. Bei dem in [5] beschriebenen Verfahren ist eine ausreichende Anzahl von Messwerten ab etwa 20 bis 30 Messwerten je Messintervall gegeben. Des Weiteren gilt die getroffene Annahme nur eingeschränkt für ein schlechtes Signal, bei dem das Signal-Rausch-Verhältnis relativ klein ist. Bei einem schlechten Signal ist die Wahrscheinlichkeit von Ausreissern relativ gross, so dass es auch in einem solchen Fall zu relativ großen Abweichungen des Messergebnisses kommen kann. Insgesamt kann festgehalten werden, dass bei den bekannten Verfahren eine statistische Messmethode zum Einsatz kommt, die umso zuverlässiger und genauer arbeitet je mehr Messwerte sie je Messintervall zur Verfügung hat.

Falls die Annahme, dass die Rauschsignalanteile des Signals eine Gaussverteilung aufweisen, tatsächlich nicht erfüllt ist, kann das mit dem bekannten Verfahren ermittelte Signal-Rausch-Verhältnis negative oder sogar komplexe Werte aufweisen. Derartige Werte können jedoch nicht zur Verbesserung des Signal-Rausch-Verhältnisses, bspw. zur Erhöhung der Sendeleistung der Nutzsignalanteile oder zur Kompensation der Rauschsignalanteile des Signals, weiterverwertet werden.

Der Einsatz der Kurtosis in der Nachrichtentechnik ist auch aus der US 4,530,076 bekannt. Dort wird die Kurtosis zum Verbessern des Signal-Rausch-Verhältnisses eines Signals eingesetzt, indem Rauschsignalanteile, die keine Gaussverteilung aufweisen, aus dem Signal eliminiert werden.

Der vorliegenden Erfindung liegt die Aufgabe zu Grunde, das Signal-Rausch-Verhältnis eines Signals mit Nutzsignalanteilen und Rauschsignalanteilen insbesondere auch dann genau und zuverlässig zu berechnen, wenn nur relativ wenige Messwerte je Messintervall vorliegen bzw. wenn nur ein relativ schlechtes Signal mit einem hohen Rauschsignalanteil vorliegt.

Zur Lösung dieser Aufgabe schlägt die Erfindung ausgehend von dem Verfahren der eingangs genannten Art vor, dass das Signal derart manipuliert wird, dass die Rauschsignalanteile mit einer höheren Wahrscheinlichkeit eine Gaussverteilung aufweisen, bevor das Signal-Rausch-Verhältnis bestimmt wird.

Das erfindungsgemäße Verfahren schafft die Voraussetzung dafür, dass die bei beim Bestimmen des Signal-Rausch-Verhältnisses nach den bekannten Verfahren getroffene Annahme in der Regel erfüllt ist. Jedenfalls ist die Annahme wesentlich häufiger erfüllt als bei dem aus dem Stand der Technik bekannten Verfahren. Mit dem erfindungsgemäßen Verfahren kann das Signal-Rausch-Verhältnis eines Signals mit Nutzsignalanteilen und Rauschsignalanteilen somit wesentlich genauer und zuverlässiger berechnet werden. Das gilt insbesondere dann, wenn nur relativ wenige Messwerte je Messintervall vorliegen bzw. wenn nur ein relativ schlechtes Signal mit einem hohen Rauschsignalanteil vorliegt.

Gemäß einer vorteilhaften Weiterbildung der vorliegenden Erfindung wird vorgeschlagen, dass das Signal in mindestens einem Durchlauf so lange manipuliert wird, bis das ermittelte Signal-Rausch-Verhältnis keinen Imaginäranteil aufweist und positiv ist. Ist der Wert des ermittelten Signal-Rausch-Verhältnisses nach einem ersten Durchlauf noch negativ oder weist er einen Imaginäranteil auf, d. h. ist der Wert nicht plausibel, wird das Signal in einem weiteren Durchlauf erneut manipuliert. Diese Schleife wird so lange durchlaufen, bis der Wert des ermittelten Signal-Rausch-Verhältnisses plausibel ist oder hilfsweise eine bestimmte Anzahl von Durchläufen erfolgt ist. Auf diese Weise kann sichergestellt werden, dass am Ende des Verfahrens in der Regel ein plausibler Wert für das Signal-Rausch-Verhältnis ausgegeben wird. Ein solcher plausibler Wert kann dann zur Verbesserung des Signal-Rausch-Verhältnisses, bspw. zur Erhöhung der Sendeleistung der Nutzsignalanteile oder zur Kompensation der Rauschsignalanteile des Signals, weiterverwertet werden.

Gemäß einer bevorzugten Ausführungsform der vorliegenden Erfindung wird vorgeschlagen, dass zu dem Signal ein Rauschsignal mit einer bekannten durchschnittlichen Leistung addiert wird, bevor das Signal-Rausch-Verhältnis bestimmt wird. Durch die Addition des Rauschsignals wird die Wahrscheinlichkeit, dass die Rauschsignalanteile des Summensignals - das ist die Summe des ursprünglichen Signals und des Rauschsignals - eine Gaussverteilung aufweisen, entscheidend erhöht. Dies macht sich insbesondere bei einen geringen Anzahl von Messwerten je Messintervall und bei schlechten Signalen positiv bemerkbar. Diese Ausführungsform der Erfindung ermöglicht auf eine einfache Weise eine deutlich genauere und zuverlässigere Bestimmung des Signal-Rausch-Verhältnisses.

Die durchschnittliche Leistung ist auf mehrere Rauschwerte des Rauschsignals bezogen, die innerhalb eines Messintervalls zu den Messwerten des Signals addiert werden.

Das Rauschsignal, das zu dem Signal addiert wird, weist vorteilhafterweise eine Gaussverteilung auf. Genauer gesagt, weisen die Rauschwerte, die zu den einzelnen Messwerten des Signals eines Messintervalls addiert werden, eine Gaussverteilung auf. Das Rauschsignal, bzw. die einzelnen Rauschwerte, können bspw. bei Bedarf mittels eines Zufallsgenerators generiert werden oder aus einem Speicher entnommen werden.

Gemäß einer weiteren vorteilhaften Ausführungsform der vorliegenden Erfindung wird vorgeschlagen, dass das Signal-Rausch-Verhältnis mit Hilfe der Kurtosis abgeschätzt wird, wobei die Kurtosis der Quotient aus dem vierten Moment des Signals und dem Quadrat des zweiten Moments des Signals ist. Ein solches Verfahren zum Abschätzen des Signal-Rausch-Verhältnisses ist an sich aus der Veröffentlichung [5] bekannt, auf die ausdrücklich Bezug genommen wird. Eine Ergänzung dieses Verfahrens durch die erfindungsgemäße Manipulation des Signals mit dem Ziel, dass die Rauschsignalanteile des Signals eine Gaussverteilung aufweisen, ergibt ein besonders einfach zu realisierendes, aber dennoch genaues und zuverlässiges Verfahren zum Bestimmen des Signal-Rausch-Verhältnisses eines Signals.

Vorteilhafterweise werden die Auswirkungen des Rauschsignals auf das Signal nach dem Bestimmen des Signal-Rausch-Verhältnisses kompensiert. Die Auswirkungen des Rauschsignals auf das Signal werden nach dem Bestimmen des Signal-Rausch-Verhältnisses vorzugsweise gemäß der Gleichung

$$\rho = \frac{(1 + a) \cdot \rho'}{a - \rho'} \tag{1}$$

kompensiert, wobei $\rho'$ das Signal-Rausch-Verhältnis des Summensignals aus der Summe des Signals und des Rauschsignals und a das Leistungsverhältnis des Signals zu dem Rauschsignal ist.

Bei mehreren Durchläufen wird vorgeschlagen, dass das Leistungsverhältnis a aus dem durchschnittlichen abgeschätzten Signal-Rausch-Verhältnis eines vorangegangenen Messintervalls bestimmt wird. Das Leistungsverhältnis a ist typischerweise gleich einem Faktor < 1 multipliziert mit dem Signal-Rausch-Verhältnis des vorangegangenen Messintervalls.

Gemäß noch einer weiteren vorteilhaften Ausführungsform der vorliegenden Erfindung wird vorgeschlagen, dass das Verfahren zum Bestimmen des Signal-Rausch-Verhältnisses eines Universal Mobile Telecommunication System (UMTS)-Signals eingesetzt wird. Bei UMTS spielt das Bestimmen bzw. Abschätzen des Signal-Rausch-Verhältnisses eine ganz entscheidende Rolle. Die meisten grundlegenden Funktionen bei UMTS wie Leistungsregelung (power control), Verbindungsübergabe (handover) etc. basieren auf einer gut funktionierenden Ermittlung des Signal-Rausch-Verhältnisses. Bei UMTS stehen für manche wichtige Dienste wie den Sprachdienst in der Regel nur relativ wenige Messwerte je Messintervall zum Bestimmen des Signal-Rausch-Verhältnisses zur Verfügung. So ist bei UMTS bspw. für die Leistungsregelung innerhalb eines Zeitschlitzes nur ein sehr kurzer Zeitraum mit entsprechend wenigen Messwerten vorgesehen. Insbesondere für sog. downlink-Verbindung von einer Basisstation zu einem Endgerät kommen die Vorteile des erfindungsgemäßen Verfahrens besonders zum Tragen, da hier die Leistung des Rauschsignalanteils von Messintervall zu Messintervall erheblich schwanken kann und deshalb eine blindabschätzende Messmethode wie das hier vorgeschlagene Verfahren angewandt werden muss.

Von besonderer Bedeutung ist die Realisierung des erfindungsgemäßen Verfahrens in der Form eines Steuerelements, das für ein Steuergerät einer Vorrichtung zum Bestimmen des Signal-Rausch-Verhältnisses eines Signals vorgesehen ist. Dabei ist auf dem Steuerelement ein Programm abgespeichert, das auf einem Rechengerät, insbesondere auf einem Mikroprozessor, ablauffähig und zur Ausführung des erfindungsgemäßen Verfahrens geeignet ist. In diesem Fall wird also die Erfindung durch ein Programm realisiert, so dass dieses mit dem Programm versehene Steuerelement in gleicher Weise die Erfindung darstellt wie das Verfahren, zu dessen Ausführung das Programm geeignet ist. Als Steuerelement kann insbesondere ein elektrisches Speichermedium zur Anwendung kommen, bspw. ein Read-Only-Memory oder ein Flash-Memory.

Als eine weitere Lösung der Aufgabe der vorliegenden Erfindung wird ausgehend von der Vorrichtung der eingangs genannten Art vorgeschlagen, dass die Vorrichtung Mittel zur Manipulation des Signals vor dem Bestimmen des Signal-Rausch-Verhältnisses aufweist, wobei die Mittel zur Manipulation das Signal derart manipulieren, dass die Rauschsignalanteile mit einer höheren Wahrscheinlichkeit eine Gaussverteilung aufweisen.

Schließlich wird als eine weitere Lösung der Aufgabe der vorliegenden Erfindung ausgehend von dem Empfänger der eingangs genannten Art vorgeschlagen, dass die Vorrichtung Mittel zur Manipulation des Signals vor dem Bestimmen des Signal-Rausch-Verhältnisses aufweist, wobei die Mittel zur Manipulation das Signal derart manipulieren, dass die Rauschsignalanteile mit einer höheren Wahrscheinlichkeit eine Gaussverteilung aufweisen.

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung. Es zeigen:

Fig. 1     eine erfindungsgemäße Vorrichtung gemäß einer bevorzugten Ausführungsform in einer schematischen Ansicht; und

Fig. 2     Diagramm zum Nachweis der Leistungsfähigkeit des erfindungsgemäßen Verfahrens.

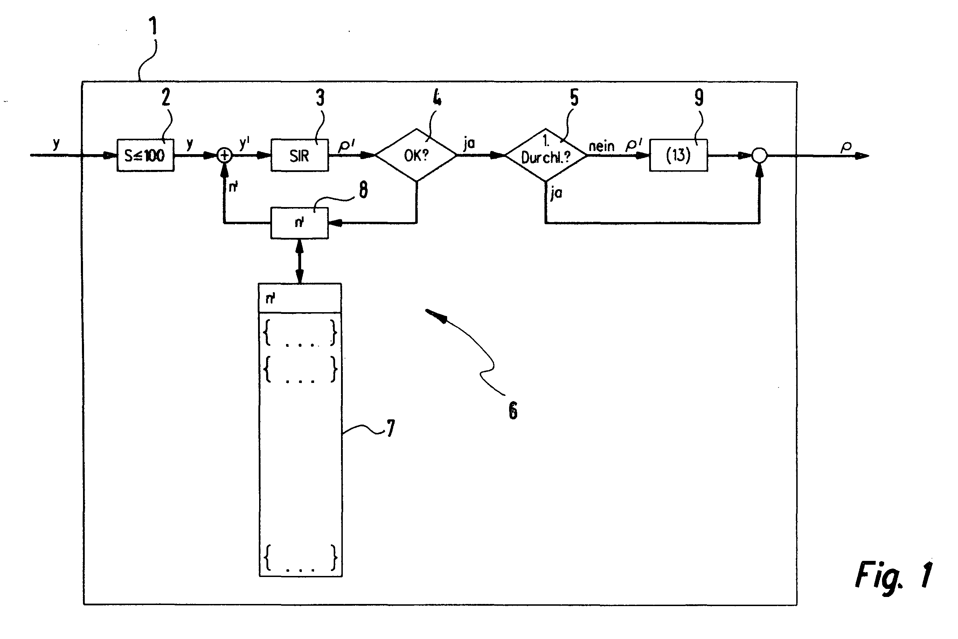

In Fig. 1 ist eine erfindungsgemäße Vorrichtung zum Bestimmen des Signal-Rausch-Verhältnisses $\rho$ eines Signals y mit dem Bezugszeichen 1 bezeichnet. Das Signal-Rausch-Verhältnis $\rho$ ist bspw. in Mobiltelefonen ein Gütekriterium für die Übertragungsqualität. Das Signal y ist bspw. als ein UMTS-Signal ausgebildet. Bei UMTS spielt das Bestimmen bzw. Abschätzen des Signal-Rausch-Verhältnisses $\rho$ eine ganz entscheidende Rolle, da die meisten grundlegenden Funktionen bei UMTS wie Leistungsregelung (power control), Verbindungsübergabe (handover) etc. auf einer gut funktionierenden, d. h. genau und zuverlässig arbeitenden, Ermittlung des Signal-Rausch-Verhältnisses $\rho$. Das Signal y weist Nutzsignalanteile x und Rauschsignalanteile n auf. Das Signal y liegt als zeitdiskretes Signal vor, wobei innerhalb eines vorgebbaren Messintervalls eine bestimmte Anzahl von Messwerten (samples) S zur Verfügung steht. Eingangs der Vorrichtung 1 wird in einem Funktionsblock 2 eine Beschränkung der Anzahl der Messwerte S je Messintervall auf maximal 100 vorgenommen. Dadurch kann der Rechenaufwand zum Bestimmen des Signal-Rausch-Verhältnisses $\rho$ in vertretbaren Grenzen gehalten werden.

In einem Funktionsblock 3 wird das Signal-Rausch-Verhältnis $\rho$ nach einem an sich aus dem Stand der Technik bekannten Verfahren abgeschätzt. Ein solches bekanntes Verfahren ist bspw. in den Veröffentlichungen von Matzner, R., Letsch, K., "SNR Estimation and Blind Equalization (Deconvolution) Using the Kurtosis", Proc. 1994 IEEE-IMS Workshop on Information Theory and Statistics, Alexandria, VA, Oct. 1994, p. 68, http://speedy.et.unibw-muenchen.de/forsch/ut/publ/itstat94/ paper.html [1]; Matzner, R., "Schätzung des Signalstörabstands mit Hilfe der Kurtosis", ITG-Diskussionssitzung "Höhere Momente: Algorithmen und ihre Anwendung", Darmstadt, Sept. 1994 [5] und in der Diplomarbeit von Panyaworayan, W. an der Universität der Bundeswehr, München, Dez. 1998 beschrieben.

Nachfolgend werden die für das erfindungsgemäße Verfahren relevanten komplexen Gleichungen im Frequenzbereich angegeben. Es versteht sich, dass durch eine Darstellung als reale Gleichung eine Vereinfachung der Gleichungen erzielt werden kann und dass die Gleichungen durch eine entsprechende Umformung ohne weiteres auch im Zeitbereich dargestellt werden können.

Es wird zunächst davon ausgegangen, dass ein Rauschsignal n' = 0 ist und somit y' = y ist. Das in [1] beschriebene bekannte Verfahren geht von der Annahme aus, dass die Nutzsignalanteile x und die Rauschsignalanteile n des Signals y statistisch unabhängig voneinander sind. Die Wahrscheinlichkeitsdichtefunktion (probabilty density function; pdf) $f_y(y)$ des Signals $y = x + n$ ergibt sich aus der Faltung der Wahrscheinlichkeitsdichtefunktion $f_x(y)$ des Nutzsignalanteils x und der Wahrscheinlichkeitsdichtefunktion $f_n(y)$ des Rauschsignalanteils n im Zeitbereich.

Die Fouriertransformierte einer Wahrscheinlichkeitsdichtefunktion wird als charakteristische Funktion (characteristic function; CF) bezeichnet. Eine Faltung im Zeitbereich entspricht einer einfachen Multiplikation im Frequenzbereich:

$$\phi_y(\omega_1, \omega_2) = \phi_x(\omega_1, \omega_2)\phi_n(\omega_1, \omega_2) \tag{2}$$

Die charakteristische Funktion $\phi_y(\omega_1, \omega_2)$ kann in einer Taylorreihe entwickelt werden. Die Koeffizienten der Taylorreihe sind die Momente der Wahrscheinlichkeitsdichtefunktion:

$$\phi_y(\omega_1, \omega_2) = \sum_{p=0}^{\infty} \frac{(-j)^p}{p!} \sum_{q=0}^{\infty} \binom{p}{q} m_{y, p-q, q} \; \omega_1^{p-q} \omega_2^q \tag{3}$$

Aufgrund dieses Zusammenhangs wird die Taylorentwicklung einer charakteristischen Funktion auch Momentenreihe genannt. Für symmetrische Wahrscheinlichkeitsdichteverteilungen ist die charakteristische Funktion eine reelle Funktion und alle Momente von ungerader Ordnung verschwinden. Durch den Einsatz der Momentenreihe zur Darstellung der charakteristischen Funktionen in Gleichung (3) führt zu dem nachfolgenden Ausdruck:

$$m_{y, k, l} = \sum_{u=0}^{k} \sum_{v=0}^{l} \binom{k}{u}\binom{l}{v} m_{x, k-u, l-v} \; m_{n, u, v} \tag{4}$$

Es ist ausreichend, mit den Momenten zweiter und vierter Ordnung zu arbeiten. Die Momente zweiter Ordnung $m_{y,2}$ und vierter Ordnung $m_{y,4}$ ergeben sich zu:

$$
\begin{aligned}
m_{y,2} &= m_{x,2,0} + m_{x,0,2} + m_{n,2,0} + m_{n,0,2} \\
m_{y,4} &= m_{x,4,0} + 2m_{x,2,2} + m_{x,0,4} + m_{n,4,0} + 2m_{n,2,2} + m_{n,0,4} + \\
&\quad + 4(m_{x,2,0} + m_{x,0,2})(m_{n,2,0} + m_{n,0,2}) + \\
&\quad + 2(m_{x,2,0} - m_{x,0,2})(m_{n,2,0} - m_{n,0,2})
\end{aligned}
\tag{5}
$$

An dieser Stelle ist es sinnvoll die sog. Kurtosis $K_y$ des Signals y einzuführen. The wichtigste Eigenschaft der Kurtosis $K_y$ ist, dass sie unabhängig ist von der Leistung des Signals y. Das bedeutet, dass die Kurtosis $K_y$ ein Formfaktor einer Wahrscheinlichkeitsdichtefunktion ist.

$$
\begin{aligned}
K_y &= \frac{m_{y,4}}{(m_{y,2})^2} \\
&= \frac{K_x S^2 + K_n N^2 + 4SN + 2(S_r - S_i)(N_r - N_i)}{(S+N)^2} \\
&\text{mit } S = S_r + S_i = m_{x,2,0} + m_{x,0,2} \text{ und} \\
&\quad\quad N = N_r + N_i = m_{n,2,0} + m_{n,0,2}
\end{aligned}
\tag{6}
$$

Die Momente vierter Ordnung des Nutzsignalanteils x und des Rauschsignalanteils n sind von der entsprechenden Kurtosis $K_x$ und $K_n$ ersetzt worden. Nach entsprechender Umformung ergibt sich eine Gleichung, die nur Momente und Kurtoses zweiter Ordnung enthält:

$$K_y = \frac{K_x S^2 + K_n N^2 + 4\,SN}{(S + N)^2} \tag{7}$$

Dies ist schon fast die Lösung des Abschätzproblems: $K_x$ und $K_n$ sind Formfaktoren der Wahrscheinlichkeitsdichtefunktionen des Nutzsignalanteils x und des Rauschsignalanteils n, die bekannt sind. $K_y$ kann durch Beobachtung des Signals y erhalten werden. Somit ist es ausreichend, die Gleichung (7) für S/N zu lösen, was das geschätzte Signal-Rausch-Verhältnis ist.

Der interessante Ausdruck der Gleichung (7) ist der gemischte Ausdruck 4SN. Die Gleichung (7) kann wesentlich besser mit einem Mass G formuliert werden, wobei im komplexen Fall G = K - 2 ist.

G ist 0 für eine Gaussverteilung und negativ für die meisten typischen modulierten und Basisbandquellen. Indem die Kurtoses K des Nutzsignalanteils x und des Signals y durch das jeweilige Mass G in Gleichung (7) ersetzt wird und unter der Annahme, dass $G_n = 0$ (gilt für ein Rauschsignal n mit einer Gaußverteilung) ergibt sich eine sehr übersichtliche Gleichung:

$$G_y = G_x\left(\frac{S}{S + N}\right)^2 = G_x\left(\frac{m_{x,2,0} + m_{x,0,2}}{m_{x,2,0} + m_{x,0,2} + m_{n,2,0} + m_{n,0,2}}\right)^2 \tag{8}$$

Mit

$$\kappa = \frac{S}{S + N} = \frac{m_{x,2}}{m_{x,2} + m_{n,2}} \tag{9}$$

ergibt sich aus Gleichung (8) ein einfacher Ausdruck für das Signal-Rausch-Verhältnis.

$$G_y = G_x\kappa^2,\ \rho = \frac{\kappa}{1 + \kappa} \tag{10}$$

Wie Gleichung (10) zu entnehmen ist, geht das bekannte Verfahren zum Bestimmen des Signal-Rausch-Verhältnisses $\rho$ von der Annahme aus, dass der Rauschsignalanteil n des Signals y eine Gaussverteilung aufweist.

Diese Annahme gilt jedoch nur, wenn je Messintervall eine ausreichend große Anzahl von Messwerten S aufgenommen wird. Bei einer zu geringen Anzahl von Messwerten S wirken sich Ausreisser wesentlich stärker auf das Messergebnis aus und bewirken eine relativ große Abweichung des Messergebnisses von dem tatsächlichen Messwert. Bei dem oben beschriebenen Verfahren ist eine ausreichende Anzahl von Messwerten ab etwa 20 bis 30 Messwerten je Messintervall gegeben. Des Weiteren gilt die getroffene Annahme für ein schlechtes Signal y, bei dem das Signal-Rausch-Verhältnis $\rho$ relativ klein ist, nur eingeschränkt. Bei einem schlechten Signal y ist die Wahrscheinlichkeit von Ausreissern relativ gross, so dass es auch in einem solchen Fall zu relativ großen Abweichungen des Messergebnisses kommen kann. Zusammenfassend kommt bei den bekannten Verfahren eine statistische Messmethode zum Einsatz, die umso zuverlässiger und genauer arbeitet je mehr Messwerte S je Messintervall zur Verfügung stehen.

Bei UMTS stehen in der Regel nur relativ wenige Messwerte S je Messintervall zum Bestimmen des Signal-Rausch-Verhältnisses $\rho$ zur Verfügung. So ist bei UMTS nach dem derzeitigen Stand für die Leistungsregelung innerhalb eines Zeitschlitzes nur ein sehr kurzer Zeitraum mit entsprechend wenigen Messwerten S vorgesehen. Bei einer downlink-Verbindung von einer Basisstation zu einem Endgerät kommt noch folgende Einschränkung hinzu, so dass faktisch nur blinde Abschätzverfahren zur Ermittlung des Signal-Rausch-Verhältnisses einzusetzen sind. Das Endgerät als Empfänger in der downlink-Verbindung erwartet Leistungsschwankungen sowohl beim Nutzsignalanteil als auch beim Rauschsignalanteil. Deshalb kann der Rauschsignalanteil nicht wie bei einer uplink-Verbindung zum Nutzsignalanteil getrennt gemessen werden. Die Anzahl der im Voraus bekannten Pilotbits ist außerdem nicht ausreichend für diese Schätzaufgabe.

Im Anschluss an den Funktionsblock 3 wird in einem Abfrageblock 4 überprüft, ob das mittels des an sich bekannten Verfahrens in Funktionsblock 3 berechnete Signal-Rausch-Verhältnis $\rho$ plausibel ist. Es ist dann plausibel, wenn es nur reelle Anteile enthält und positiv ist. Falls das Signal-Rausch-Verhältnis $\rho$ plausibel ist, wird in einem nachfolgenden Abfrageblock 5 überprüft, ob sich das Verfahren noch in dem ersten Durchlauf befindet. Falls das der Falls ist, ist ρ = ρ' und das in Funktionsblock 3 bestimmte Signal-Rausch-Verhältnis ρ wird ausgegeben.

Falls in dem Abfrageblock 4 jedoch festgestellt wird, dass das in Funktionsblock 3 ermittelte Signal-Rausch-Verhältnis ρ nicht plausibel ist, wird erfindungsgemäß zu Mitteln 6 zur Manipulation des Signals y verzweigt. Die Mittel 6 manipulieren das Signal y derart, dass die Rauschsignalanteile n mit einer höheren Wahrscheinlichkeit eine Gaussverteilung aufweisen. In dem vorliegenden Ausführungsbeispiel sind die Mittel 6 derart ausgebildet, dass ein Rauschsignal n' zu dem Signal y addiert wird. Das Rauschsignal n' hat eine Gaussverteilung. Das Rauschsignal n' besteht aus einer Vielzahl einzelner Rauschwerte, die in Form einer Liste oder Tabelle in einem Speicherelement 7 gespeichert sind. Die Rauschwerte werden bspw. im Vorfeld durch einen Zufallsgenerator (nicht dargestellt) generiert und in dem Speicherelement 7 abgelegt. Zu jedem Messwert S innerhalb eines Messintervalls wird ein entsprechender Rauschwert addiert. Der entsprechende Rauschwert wird mittels eines Auswahlelements 8 ausgewählt. Im einfachsten Fall wird ein Rauschwert nach dem anderen aus der Liste des Speicherelements 7 ausgelesen. Es ist aber auch denkbar, dass ein Rauschwert zufällig aus der Liste ausgewählt wird.

In Funktionsblock 3 wird dann das Signal-Rausch-Verhältnis ρ' des Summensignals y' = y + n' berechnet.

$$\rho' = \frac{m_{x,2}}{m_{n,2} + m_{n',2}} \qquad\qquad (11)$$
$$= \frac{a\rho}{a + 1 + \rho}$$

Die Variable a ist das Leistungsverhältnis des Signals y zu dem Rauschsignal n'. Das Leistungsverhältnis a kann aus dem geschätzten Wert des Signal-Rausch-Verhältnisses ρ aus einem vorangegangenen Messintervall adaptiv bestimmt werden. Das Leistungsverhältnis a ist typischerweise gliech einem Faktor f < 1 multipliziert mit dem Signal-Rausch-Abstand des vorangegangenen Messintervalls. Ein typischer Wert für den Faktor f ist f ≈ 0,25.

In dem Abfrageblock 4 wird dann überprüft, ob das in Funktionsblock 3 ermittelte Signal-Rausch-Verhältnis ρ' plausibel ist. Falls dem so ist, wird in dem nachfolgenden Abfrageblock 5 überprüft, ob sich das Verfahren noch in dem ersten Durchlauf befindet. Da sich das Verfahren bereits in seinem zweiten Durchlauf befindet, wird zu einem Funktionsblock 9 verzweigt, in dem das Signal-Rausch-Verhältnis ρ' des Summensignals y' in das tatsächliche Signal-Rausch-Verhältnis ρ des Signals y umgerechnet wird. Es gilt der nachfolgende Zusammenhang:

$$\rho = \frac{(1 + a)\rho'}{a - \rho'} \qquad\qquad (1)$$

Der ermittelte Wert für das Signal-Rausch-Verhältnis ρ wird dann ausgegeben und das erfindungsgemäße Verfahren ist beendet.

Falls sich in dem Abfrageblock 4 ergibt, dass das ermittelte Signal-Rausch-Verhältnis ρ' nicht plausibel ist, wird noch einmal zu den Mitteln 6 zur Manipulation des Signals y verzweigt und zu dem Signal y ein Rauschsignal n' addiert. Das für den weiteren Durchlauf gewählte Rauschsignal n' unterscheidet sich in der Regel von dem Rauschsignal n' der vorangegangenen Durchläufe. Diese Schleife wird so lange durchlaufen, bis ein plausibler Wert für das Signal-Rausch-Verhältnis ρ' vorliegt. Falls eine vorgebbare Anzahl von Durchläufen absolviert wurde, ohne dass ein plausibler Wert ermittelt werden konnte, wird das Verfahren abgebrochen.

Ziel des erfindungsgemäßen Verfahrens ist es, eine Gaussverteilung des Summensignals y' zu erzielen. Dazu ist es nicht erforderlich, dass das Rauschsignal n' eine Gaussverteilung aufweist. Vorteilhafterweise hat das Rauschsignal n' jedoch eine Gaussverteilung. Die durchschnittliche Leistung des Rauschsignals n' ist bekannt. Sie beträgt entweder 0 oder wird nach dem Ermitteln des Signal-Rausch-Verhältnisses ρ kompensiert.

Das erfindungsgemäße Verfahren wurde für zeitdiskrete Signale y(k), k = 0, 1, 2, 3, ..., beschrieben. Es ist aber ebenso auf zeitkontinuierliche Signale y(t) anwendbar.

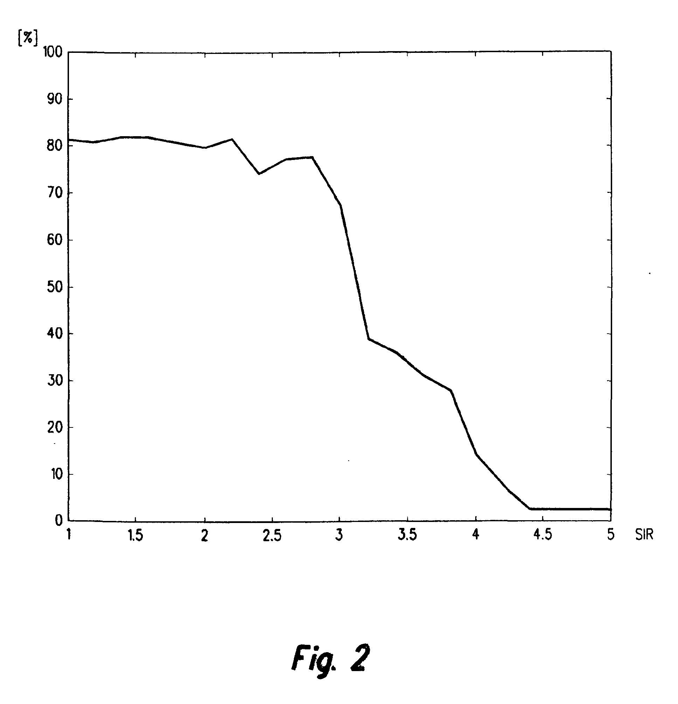

In Fig. 2 ist ein Diagramm zum Nachweis der Leistungsfähigkeit des erfindungsgemäßen Verfahrens dargestellt. Das Diagramm enthält all diejenigen Signal-Rausch-Verhältnisse ρ, die nach dem ersten Durchlauf unplausibel (mit imaginärem Anteil und/oder negativ) waren (entspricht 100%). Auf der Abszisse ist das Signal-Rausch-Verhältnis ρ aufgetragen. Auf der Ordinate ist die prozentuale Anzahl der ermittelten Signal-Rausch-Verhältnisse ρ aufgetragen, für die mit Hilfe des erfindungsgemäßen Verfahrens durch Manipulation des Signals y ein plausibler Wert erhalten wurde. Das in Fig. 2 dargestellte Diagramm beruht auf einem Signal y, für das 20 Messwerte S je Messintervall zur Verfügung standen. Die maximale Anzahl der Durchläufe wurde auf 30 beschränkt.

In Fig. 2 ist deutlich zu erkennen, dass das erfindungsgemäße Verfahren insbesondere bei schlechten Signalen y, also bei kleinen Signal-Rausch-Verhältnissen ρ, insbesondere bei ρ < 3, eine deutliche Erhöhung der Anzahl der plausiblen Werte für das Signal-Rausch-Verhältnis ρ bewirkt. Da nur die plausiblen Werte weiter verarbeitet werden können, kann eine Datenübertragung mit dem erfindungsgemäßen Verfahren wesentlich besser optimiert werden.

**Patentansprüche**

1. Verfahren zum Bestimmen des Signal-Rausch-Verhältnisses (ρ) eines Signals (y) mit Nutzsignalanteilen (x) und Rauschsignalanteilen (n) unter der Annahme, dass die Rauschsignalanteile (n) eine Gaussverteilung aufweisen, **dadurch gekennzeichnet, dass** das Signal (y) derart manipuliert wird, dass die Rauschsignalanteile (n) mit einer höheren Wahrscheinlichkeit eine Gaussverteilung aufweisen, bevor das Signal-Rausch-Verhältnis (ρ) bestimmt wird.

2. Verfahren nach Anspruch 1, **dadurch gekennzeichnet, dass** das Signal in mindestens einem Durchlauf so lange manipuliert wird, bis das ermittelte Signal-Rausch-Verhältnis (ρ) keinen Imaginäranteil aufweist und positiv ist.

3. Verfahren nach Anspruch 1 oder 2, **dadurch gekennzeichnet, dass** zu dem Signal (y) ein Rauschsignal (n') mit einer bekannten Leistung addiert wird, bevor das Signal-Rausch-Verhältnis (ρ) bestimmt wird.

4. Verfahren nach Anspruch 3, **dadurch gekennzeichnet, dass** das Rauschsignal (n') eine Gaussverteilung aufweist.

5. Verfahren nach einem der Ansprüche 1 bis 4, **dadurch gekennzeichnet, dass** das Signal-Rausch-Verhältnis (ρ) mit Hilfe der Kurtosis ($K_y$) abgeschätzt wird, wobei die Kurtosis ($K_y$) der Quotient aus dem vierten Moment ($m_{y,4}$) des Signals (y) und dem Quadrat des zweiten Moments ($m_{y,2}$) des Signals (y) ist.

6. Verfahren nach einem der Ansprüche 3 bis 5, **dadurch gekennzeichnet, dass** die Auswirkungen des Rauschsignals (n') auf das Signal (y) nach dem Bestimmen des Signal-Rausch-Verhältnisses (ρ) kompensiert werden.

7. Verfahren nach Anspruch 6, **dadurch gekennzeichnet, dass** die Auswirkungen des Rauschsignals (n') auf das Signal (y) nach dem Bestimmen des Signal-Rausch-Verhältnisses (ρ) gemäß der Gleichung

$$\rho = \frac{(1 + a) \cdot \rho'}{a - \rho'} \tag{1}$$

kompensiert werden, wobei ρ' das Signal-Rausch-Verhältnis des Summensignals (y') aus der Summe des Signals (y) und des Rauschsignals (n') und a das Leistungsverhältnis des Signals (y) zu dem Rauschsignal (n') ist.

8. Verfahren nach Anspruch 7, **dadurch gekennzeichnet, dass** a aus dem durchschnittlichen abgeschätzten Signal-Rausch-Verhältnis (ρ) eines vorangegangenen Durchlaufs des Verfahrens bestimmt wird.

9. Verfahren nach einem der Ansprüche 1 bis 8, **dadurch gekennzeichnet, dass** das Verfahren zum Bestimmen des Signal-Rausch-Verhältnisses (ρ) eines Universal Mobile Telecommunication System (UMTS)-Signals (y) eingesetzt wird.

10. Steuerelement, insbesondere Read-Only-Memory oder Flash-Memory, für ein Steuergerät einer Vorrichtung zum Bestimmen des Signal-Rausch-Verhältnisses (ρ) eines Signals (y), auf dem ein Programm abgespeichert ist, das auf einem Rechengerät, insbesondere auf einem Mikroprozessor, ablauffähig und zur Ausführung eines Verfahrens nach einem der vorangehenden Ansprüche geeignet ist.

11. Vorrichtung zum Bestimmen des Signal-Rausch-Verhältnisses (ρ) eines Signals (y) mit Nutzsignalanteilen (x) und Rauschsignalanteilen (n) unter der Annahme, dass die Rauschsignalanteile (n) eine Gaussverteilung aufweisen, **dadurch gekennzeichnet, dass** die Vorrichtung Mittel zur Manipulation des Signals (y) vor dem Bestimmen des Signal-Rausch-Verhältnisses (ρ) aufweist, wobei die Mittel zur Manipulation das Signal (y) derart manipulieren, dass die Rauschsignalanteile (n) mit einer höheren Wahrscheinlichkeit eine Gaussverteilung aufweisen.

12. Empfänger einer nachrichtentechnischen Übertragungsstrecke mit einer Vorrichtung zum Bestimmen des Signal-Rausch-Verhältnisses (ρ) eines empfangenen Signals (y) mit Nutzsignalanteilen (x) und Rauschsignalanteilen (n) unter der Annahme, dass die Rauschsignalanteile (n) eine Gaussverteilung aufweisen, **dadurch gekennzeichnet, dass** die Vorrichtung Mittel zur Manipulation des Signals (y) vor dem Bestimmen des Signal-Rausch-Verhältnisses (ρ) aufweist, wobei die Mittel zur Manipulation das Signal (y) derart manipulieren, dass die Rauschsignalanteile (n) mit einer höheren Wahrscheinlichkeit eine Gaussverteilung aufweisen.

Fig. 1

EP 1 158 304 A2

**Fig. 2**